# EUROPEAN PATENT APPLICATION

(11) **EP 1 571 715 A1**
(43) Date of publication of application: **07.09.2005**
(21) Application number: 04005063.5
(22) Date of filing: 04.03.2004
(51) Int. Cl.: H01L 33/00

(54) **Method for producing white light emission by means of secondary light exitation and its product**

(71) Applicant: NAN YA PLASTICS CORPORATION, Taipei (TW)
(72) Inventor: Yang, Ming-Fa, Taipei (TW); Chang, Chi-Ming, Taipei (TW); Fung, Dein-Run, Taipei (TW); Shieh, Sung-Yueh, Taipei (TW)
(74) Representative: Helms, Joachim

(57) **Abstract**

A method for producing white light emission by means of secondary light excitation comprising the application of a light source such as Light Emitting diode (LED) or Laser Diode (LD) which may generate ultra violet light or violet light, with wavelength between 360 ∼ 420 nm. to excite blue phosphor to produce the broadband first exciting light spectrum having blue light as the main wave crest. The first exciting light in turn excites the yellow phosphor having lower energy level to produce the broadband secondary exciting light having yellow light as the main wave crest. The amount of the two phosphors are adjusted to some specific ratio so that the first exciting light spectrum and the secondary exciting light spectrum emitted by the phosphors enable the light-blend and complementary effect to produce a complete white light spectrum; Besides, red phosphor or green phosphor which can be excited by ultra violet or violet light can be added to adjust the color rendering effect and color temperature of the white light produced by this method and obtain other kinds of light source of different color.

## Description

### BACKGROUND OF THE PRESENT INVENTION

### 1. Field of the Present Invention

The invention relates to a method for producing white light emission by means of secondary light excitation, particularly, relates to a white light emitting component which may generate high purity white light emission by employing semiconductor chip which generates ultra violet light or violet light with wave length between 360 ∼ 420 nm as light source to excite the packing material containing a blend of blue phosphor and yellow phosphor coated on the semiconductor chip to produce high purity white light emission.

### 2. Description of Prior Act

Today the traditional light source popularly used by the public has the drawbacks of high heat radiation, heavy metal pollution and high electricity consumption. In view of these drawbacks the traditional light source must be superseded by a new light source product which has higher power conversion efficiency and meets environmental protection requirements to achieve the purpose of saving energy and fulfilling the requirements of environmental protection.

The while light emitting component made of light emitting diode (LED) or laser diode (LD) has a service life as long as 100 thousand hours and the advantages of saving electricity, smaller size, higher response speed, better whether-resistance, isn't damageable, high color rendering effect and having color temperature close to that of the sunlight, this type of white light has been used for some applications. Especially, its unique advantages of highly reduced heat radiation pollution and no heavy metal pollution such as mercury have absolutely met the requirements of environmental protection that have qualified it the most idealized light source, and has been generally recognized as the major light source for the 21 century.

In the early stage the manufacturing method of white light emitting component, such as white LEDs was coating the blue LED with the yellow phosphor. However the color quality of the white light LED obtained by this method was not so satisfied; or the white light emission was obtained by combining the red LED, blue LED and green LED to form a light emitting component which enables a blend of the three primary colored lights of red, blue and yellow to generate white light. And, since the driving voltage for the red LED, blue LED and green LED in the component were different respectively, it caused the drawbacks of complicated design of driving electric circuit, high electricity consumption and high manufacturing cost.

In the US Patent No. 6.069.440 owned by Nichia company a method was firstly proposed by employing Indium gallium Nitride (InGaN) LED to generate blue light which in turn excites the phosphor of Yttrium Aluminum Garnet (Y₃Al₅O₁₂, i.e. YAG) to generate yellow light, then the blend of blue light and yellow light may produce high quality white light emission.

However when a light source has a wave length lower than 420nm, it also has low light excitation efficiency on YAG phosphor. Besides, since the InGaN LED for generating blue light has the optimal light emitting efficiency at the wave length around 400 nm, it shall not be able to obtain the white light emission effectively if the blue light generated by InGaN LED is employed to excite YAG phosphor. In other words, the US Patent No. 6,068,440 owned by Nichia Company is inappropriate for producing a white light emission with wave length around 400 nm.

Therefore, in order to improve the aforementioned drawback, General Electric Company disclosed a method in the US Patent No. 6,255,670 which employed the ultra violet light LED to excite red, green and blue phosphor to produce the three primary colored lights of red, green and blue, and have the red, green and blue light blended together to form white light. However, since the light source having a wave length around 400 nm still has poor light excitation effect on red phosphor, the method proposed in the U.S. Patent No. 6,255,670 is still not so appropriate for generating white light with wave length around 400 nm.

### SUMMARY OF THE PRESENT INVENTION

The major purpose of the invention is to disclose a method for producing white light emission by means of secondary light excitation which is appropriate for generating white light emission with wave length around 400 nm. The method employs the violet or ultra violet LED or LD as the light source to generate violet or ultra violet light having wave length ranged from 360nm to 420 nm to excite the first blue phosphor and generate the first light spectrum having blue light as the main wave crest, then the first spectrum excites the secondary yellow phosphor to generate the secondary spectrum having the main wave crest of yellow light. Then the blend of the first spectrum and the secondary spectrum is capable of forming white light emission to improve the drawback of the aforementioned US Patent No. 6.069,440 and US Patent No. 6,255,670 which are in appropriate for producing the white light emission with wave length around 400 nm.

The minor purpose of the invention is to disclose a white light emitting component which may emit high purity white light, and is constructed by semiconductor chip for emitting the violet or ultra violet light having wave length between 360 ~ 400 nm and the resin packing layer coated on the semiconductor chip. The violet or ultra violet semiconductor chip may emit violet or ultra violet light having wave length between 360 ~ 420 nm which can excite the phosphors contained in the resin packing layer of the semiconductor chip by means of secondary light excitation to emit blue and yellow light, and after light blending procedure a white light emission may be obtained.

Another purpose of the invention is to disclose a light emitting component for emitting white light of which the resin packing layer contains red or green phosphor which may be excited by violet or ultra violet light for adjusting the characteristics of the white light emission including color rendering effect and color temperature.

### BRIEF DESCRIPTION OF THE DRAWING FIGURES

Figure 1 is the flow diagram describing the method of the invention for generating white light emission by means of secondary light excitation.
Figure 2 is the construction drawing of the white light emitting component (10) of the invention which generates white light emission by means of secondary light excitation.
Figure 3 is the spectrum of ultra violet light emitted by the light emitting component of the invention when ultra violet LED chip (20) is employed.
Figure 4 is the spectrum of violet light emitted by the light emitting component of the invention when violet LED chip (20) is employed as the light source in the invention.
Figure 5 is the broadband first spectrum with blue light emitted by the blue phosphor (40) which is excited by ultra violet light when the ultra violet LED chip (20) is employed as the light source in the invention.
Figure 6 is the broadband first spectrum with blue light as the main wave crest emitted by the blue phosphor (40) which is excited by violet light when the violet LED chip (20) is employed as the light source in the invention.
Figure 7 is the spectrum of yellow light emitted by the yellow phosphor (50) which is excited by ultra violet light when the ultra violet LED chip (20) is employed as the light source in the invention.
Figure 8 is the spectrum of yellow light emitted by the yellow phosphor (50) which is excited by violet light when violet LED chip (20) is employed as the light source in the invention.
Figure 9 is the secondary spectrum of the yellow light (55) emitted by the yellow phosphor (50) which is excited by the blue light (45), and the blue light is emitted by the blue phosphor (40) which is excited by the ultra violet light when the ultra violet LED chip (20) is employed as the light source in the invention.
Figure 10 is the spectrum of white light produced by means of the secondary light excitation of the invention.
Figure 11 is the construction drawing of the secondary example of embodiment of the white light emitting component (10) of the invention.
Figure 12 is the construction drawing of the third example of embodiment of the white light emitting component (10) of the invention.

### DETAILED DESCRITION OF THE PREFERRED EMBODIMENTS

As based on the photo effect function, under the condition of photopic vision, the leaf green colored light with wave length 555 nm has the highest photo effect value. Therefore, when the phosphors are excited by the light of short wave length emitted by a LED chip, the light spectrum of longer wave length can be emitted by the component with better light excitation effect. Moreover, since the shorter wave length of the light source will enable higher energy conversion efficiency, the present invention employs violet or ultra violet light source to excite blue phosphor to enable a light spectrum emitted by blue phosphor having blue light as the main wave crest, and then the blue light will excite the yellow phosphor and cause the yellow phosphor to emit a light spectrum having yellow light as the main wave crest that may provide the best light conversion efficiency.

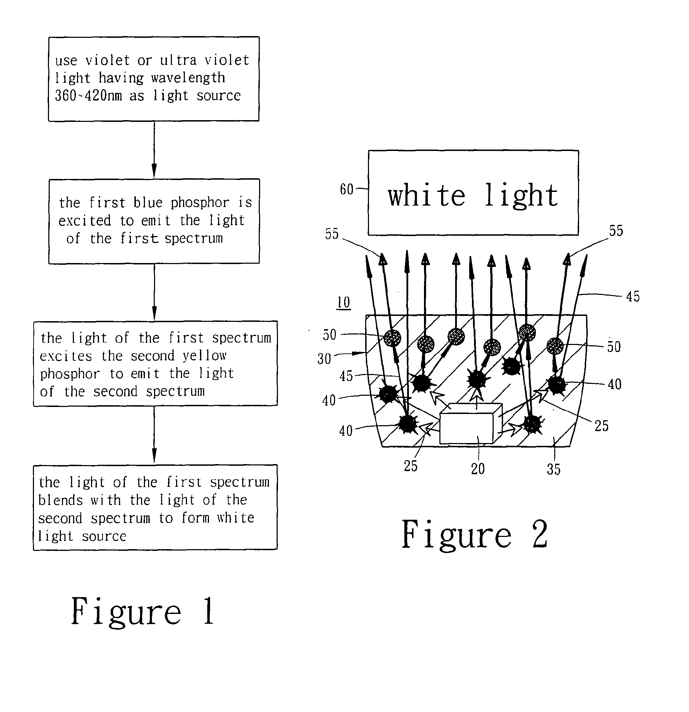

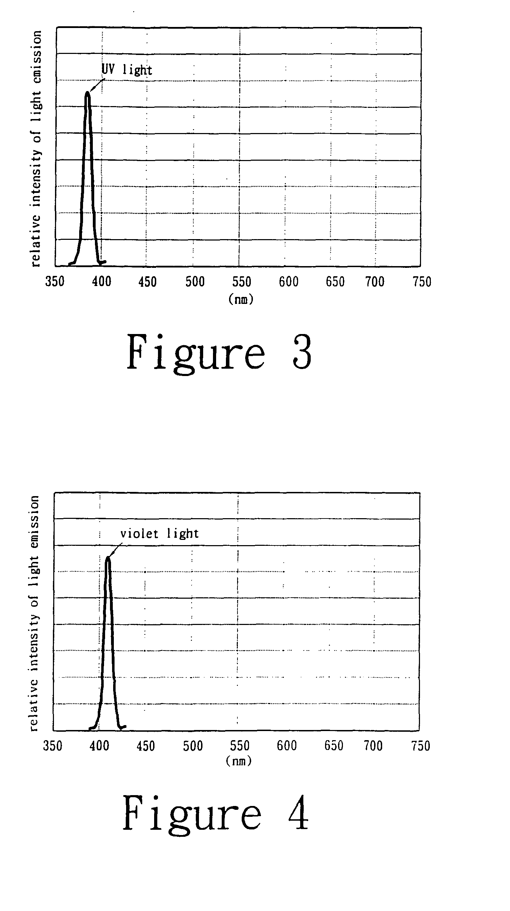

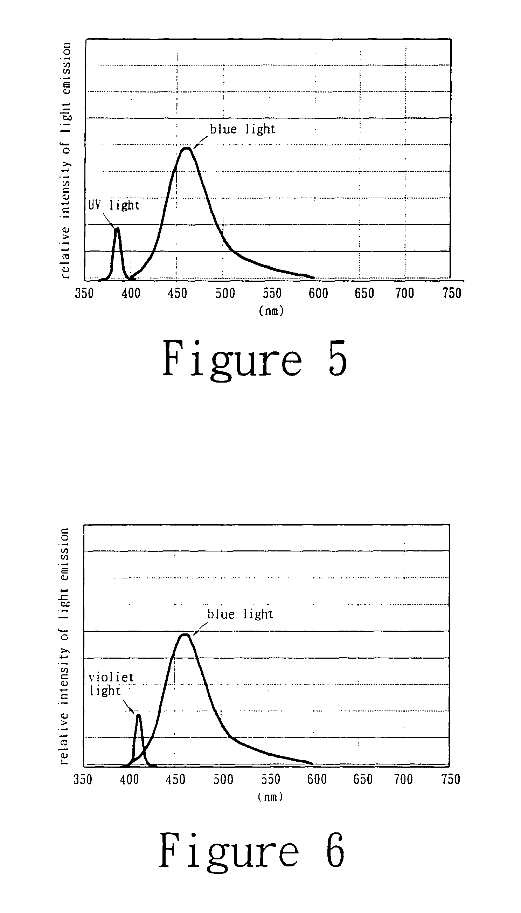

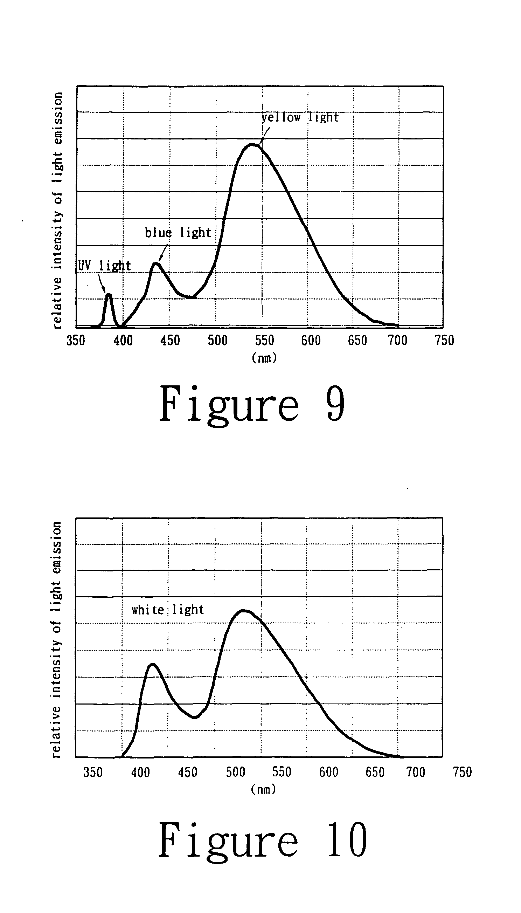

The method for producing white light emission by means of secondary light excitation as disclosed in the present invention is based on the principle as depicted in Figure 1. The white light emitting component (10) shown in Figure 2 is the practical application of the invention in which the semiconductor chip (20) capable to emit the ultra violet light spectrum as shown in Figure 3 or the violet light spectrum shown in Figure 4 is employed as light emitting component, i.e. the ultra violet or violet LED or LD having light wavelength between 360 ~ 420 nm is employed to produce light source, and the violet or ultra violet light (25) emitted by the violet and ultra violet LED chip (20) is employed to excite the blue phosphor (40) of specific composition that enables the blue phosphor (40) of the invention to emit the broadband first light spectrum having blue light (45) as the main wave crest as shown in Figure 5 or Figure 6, and then the blue light (45) of the first spectrum excites the yellow phosphor (50) of specific composition to enable the yellow phosphor (50) to emit the broadband second light spectrum of having yellow light (55) as the main wave crest as shown in Figure 9. Further, the first spectrum having blue light as the main wave crest and the secondary spectrum having yellow light as the main wave crest emitted by the blue phosphor (40) and yellow phosphor (50) of the invention blend with each other to enable the complementary effect to produce a high purity white light (60) of complete band of spectrum which is close to the three bands of spectrum of RGB.

The method for generating white light (60) by using light source of short wavelength is the method disclosed in the invention for producing white light emission by means of secondary light excitation. In addition, the white light (60) produced from light blend of this method is close to the sunlight in nature that qualifies it the ideal light source which meets the requirement of illumination needed by the public, and eliminates the inherent drawbacks of uneven light blend and insufficient brightness of the prior art in this field often occurred during the blend of the three bands of light spectrum produced by light excitation by violet or ultra violet light on three kinds of phosphor of red, green and blue.

The blue phosphor (40) used in the present invention has a composition obtained by selecting from the group consisting of Sr₁₀(PO₄)₆Cl₁₂:Eu²⁺, Ca₁₀(PO₄)₆Cl₁₂:Eu²⁺, Ba₁₀(PO₄)₆Cl₁₂:Eu²⁺, Sr₅(PO₄)₃Cl:Eu²⁺,and (BaMgAl₁₀O₁₇:Eu²⁺,Mn²⁺) which may absorb whole or part of the violet or ultra violet light (25) emitted by violet or ultra violet LED chip (20).

When ultra violet LED chip (20) is used for producing light source, the blue phosphor (40) is excited by the ultra violet light (25) emitted by the LED chip (20) to emit the broadband first spectrum with blue light (45) as the main wave crest as shown in Figure 5.

When the violet LED chip (20) is used for generating light source, the blue phosphor (40) is excited by the violet light (25) emitted by the LED chip (20) to emit the broadband first spectrum with blue light (45) as the main wave crest as shown in Figure 6.

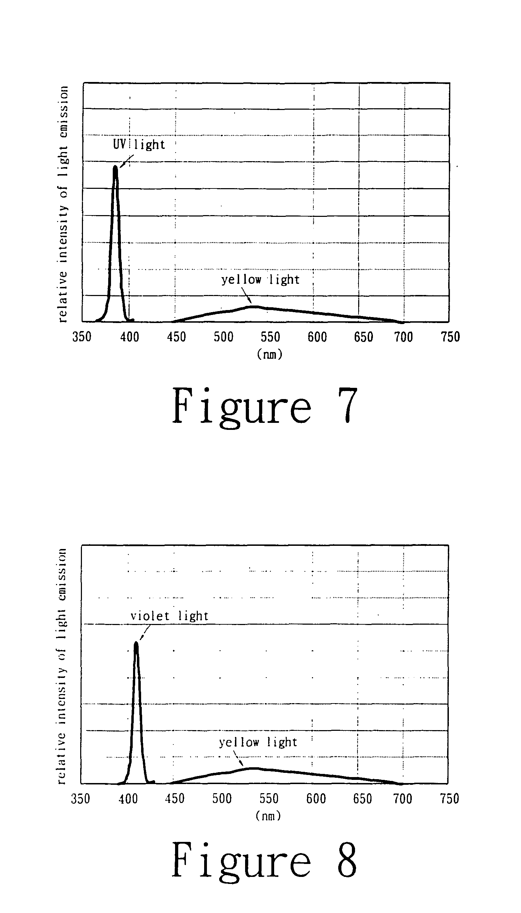

The yellow phosphor (50) used in the present invention has a composition obtained by selecting from the group consisting of Y₃Al₅O₁₂:Ce³⁺, Y₃Ga₅O₁₂:Ce³⁺, Gd₃Al₅O₁₂:Ce³⁺, and Gd₃Ga₅O₁₂:Ce³⁺. As illustrated in Figure 7 and Figure 8, the yellow phosphor (50) used in the invention has poor light-excitation effect when excited by violet or ultra violet light (25), but it can absorb whole or part of the blue light (45) emitted by the blue phosphor (40).

Again, when ultra violet LED chip (20) is used in the invention, the blue phosphor (40) is excited by ultra violet light to emit blue light (45) which in turn excites the yellow phosphor (50) of the invention to emit the broadband second light spectrum with yellow light (55) as the main crest as shown in Figure 9.

Based on the above, the desired white light may be obtained simply by adjusting the composition and amount of the blue phosphor (40) and yellow phosphor (50) to match the violet or ultra violet LED chip capable for generating violet or ultra violet light of different wave length.

Also, simply by adjusting the composition and amount of the blue phosphor (40) and the yellow phosphor (50) the lightening characteristics of the white light (60) such as color rendering effect and color temperature can be easily adjusted. Besides, by adding into the aforementioned phosphors the proper amount of green phosphor and red, phosphor which may be excited by ultra violet or violet light the color temperature of the white light (60) or color rendering effect can be easily adjusted, or the white light (60) may be altered into different kinds of colored light.

The red phosphor used in the invention has a composition obtained by selecting from the group consisting of Y₂O₂S:Eu²⁺,Bi³⁺ ` YVO₄:Eu²⁺,Bi³⁺ ` SrS:Eu²⁺ ` SrY₂S₄:Eu²⁺ ` CaLaS₄:Ce³⁺ ` CaS:Eu²⁺ ` and SrS:Eu²⁺.

The green phosphor used in the invention has a composition obtained by selecting from the group consisting of (BaMg₂Al₁₆O₂₇:Eu²⁺,Mn²⁺), YBO₃:Ce³⁺, Tb³⁺, SrAl₂S₄:Eu²⁺, BaAl₂S₄:Eu²⁺, CaAl₂S₄:Eu²⁺, SrGa₂S₄:Eu²⁺, BaGa₂S₄:Eu²⁺, and CaGa₂S₄:Eu²⁺.

### PRACTICAL APPLICATION OF THE INVENTION

### Example 1

As shown in Figure 2 is the method for producing white light emission by means of secondary light excitation as disclosed in the present invention which may be practically applied on the while light emitting component (10) to generate high purity white light for the purpose of indoor illumination, special illumination, background light source of LCD, scanner, FAX machine, mobile phone and military illumination etc.

The white light emitting component (10) of the invention comprises a violet or ultra violet LED chip (20) for generating the violet or ultra violet light having wavelength between 360-420 nm and a resin packing layer (30) coated on the ultra violet or violet LED chip (20) among which the resin packing layer (30) is made by mixing the packing material (35) with blue phosphor (40) and yellow phosphor (50) or further to include the red phosphor and green phosphor, and is hardened through heat curing or light curing process.

The blue phosphor (40) is selected from the group consisting of Sr₁₀(PO₄)₆Cl₁₂:Eu²⁺, Ca₁₀(PO₄)₆Cl₁₂:Eu²⁺, Ba₁₀(PO₄)₆Cl₁₂:Eu²⁺, Sr₅(PO₄)₃Cl:Eu²⁺, and (BaMgAl₁₀O₁₇:Eu²⁺,Mn²⁺).

The yellow phosphor (50) is selected from the group consisting of Y₃Al₅O₁₂:Ce³⁺, Y₃Ga₅O₁₂:Ce³⁺, Gd₃Al₅O₁₂:Ce³⁺, and Gd₃Ga₅O₁₂:Ce³⁺. The green phosphor is selected from one of the phosphors of (BaMg₂Al₁₆O₂₇:Eu²⁺,Mn²⁺), (YBO₃:Ce³⁺,Tb³⁺), SrAl₂S₄:Eu²⁺, BaAl₂S₄:Eu²⁺, CaAl₂S₄:Eu²⁺, SrGa₂S₄:Eu²⁺, BaGa₂S₄:Eu²⁺, and CaGa₂S₄:Eu²⁺.

The red phosphor is selected from the group consisting of (Y₂O₂S:Eu²⁺,Bi³⁺), (YVO₄:Eu²⁺,Bi³⁺), SrS:Eu²⁺, SrY₂S₄:Eu²⁺, CaLaS₄:Ce³⁺, CaS:Eu²⁺, and SrS:Eu²⁺.

Assume that the total weight of packing material (35) and the phosphors including blue phosphor (40), yellow phosphor (50), red phosphor and green phosphor of the white light emitting component (10) is A; the weight of the packing material (35) is E; the weight of the blue phosphor (40) is B; the weight of the yellow phosphor (50) is Y; the weight of the red phosphor is R; and the weight of the green phosphor is G; then the relationship between the weight of each individual ingredient should fulfill the following condition:
E ≧ 50% A;
B+Y+R+G ≦ 50% A:
5% A ≦ B ≦ 40% A:
5% A ≦ Y ≦ 40% A;
0.001% A ≦ R ≦ 20% A; and
0.0001% A ≦ G ≦ 20% A.

### Example 2

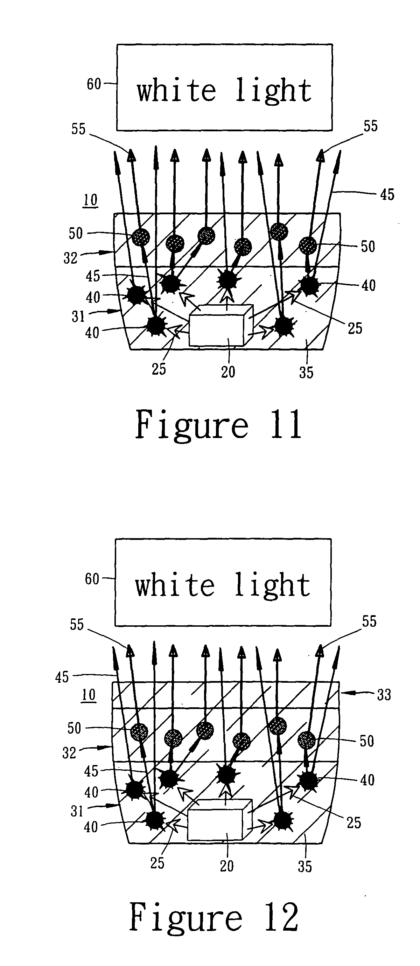

Referring to Figure 11, the second preferred embodiment of the white light emitting component (10) is formed by mixing the packing material (35) and the blue phosphor (40) to form coating layer coated on the ultra violet or violet LED chip (20) to form a first coating layer (31), and, after the first coating layer (31) is hardened through heat curing or light curing process, the mixture formed by the packing material (35), yellow phosphor (50), blue phosphor (40), red phosphor, and green phosphor is coated on the first coating layer (31) to form a second coating layer (32) which is then hardened by heat curing or light curing process.

And, the composition of the first coating layer (31) and the second coating layer (32) of the second preferred embodiment of the white light emitting component (10) shall fulfill the following relationship in weight:
(a) the first coating layer(31):
   Assume that the total weight of the packing material (35) and blue phosphor (40) is A. the weight of the packing material is E and the weight of the blue phosphor (40) is B, then

      E ≧ 50% A ; 5% A ≦ B ≦ 50% A ;
(b) the second coating layer (32):
   Assume that the total weight of the packing material (35), yellow phosphor (50), red phosphors and green phosphor is X, the weight of the packing material (35) is E, the weight of the yellow phosphor is Y, the weight of the red phosphor is R and the weight of the green phosphor is G, then
      E ≧ 50% X;
      Y+R+G ≦ 50% X;
      5% X ≦ Y ≦ 50% X;
      0.001% X ≦ R ≦ 20% X; and
      0.0001% X ≦ G ≦ 20%X.

### Example 3

As depicted in Figure 12, a third layer (33) formed by the coating material (35) shall be coated on the aforesaid second coating layer (32) of the example 2, and is hardened by the same heat curing or light curing process to form the third preferred embodiment of the white light emitting component (10) of the invention. This type of coating may increase the conversion efficiency of the blue phosphor (40) against ultra violet or violet light, and the remaining small amount of unconverted ultra violet light or violet light may be absorbed or converted by the yellow phosphor (50) of the second coating layer (32) that may enable a better light conversion efficiency which may more effectively convert the invisible ultra violet light into visible light.

And, the composition of the first coating layer (31) and the second coating layer (32) of the third preferred embodiment of the white light emitting component (10) shall fulfill the following relationship in weight:
(a) the first coating layer(31):
   Assume that the total weight of the packing material (35) and blue phosphor (40) is A, the weight of the packing material is E and the weight of the blue phosphor (40) is B, then

      E ≧ 50% A ; 5% A ≦ B ≦ 50% A ;
(b) the second coating layer (32):
   Assume that the total weight of the packing material (35), yellow phosphor (50), red phosphors and green phosphor is X, the weight of the packing material (35) is E, the weight of the yellow phosphor is Y, the weight of the red phosphor is R and the weight of the green phosphor is G, then
      E ≧ 50% X;
      Y+R+G ≦ 50% X;
      5% X ≦ Y ≦ 50% X;
      0.001% X ≦ R ≦ 20% X; and
      0.0001% X ≦ G ≦ 20%X.

## Claims

1. A method for producing white light emission by means of the secondary light excitation, wherein the light emitting component for generating violet or ultra violet light is employed to generate violet or ultra violet light with wavelength between 360 ∼ 420 nm which excites the first blue phosphor to emit the light of the first spectrum, and the light of the first spectrum excites the second yellow phosphor to emit the light of the secondary spectrum, then the light of the first spectrum blends with the light of the secondary spectrum to produce white light emission.

2. The method as described in claim 1, wherein the light emitting component used as light source is violet or ultra violet Light Emitting Diode (LED).

3. The method as described in claim 1, wherein the light emitting component used as light source is violet or ultra violet Laser Diode (LD).

4. The method as described in claim 1, wherein the color temperature and color rendering effect of white light may be adjusted by adjusting the weight proportion of blue phosphor and yellow phosphor.

5. The method as described in claim 1, wherein the light source of different colors may be obtained by adding proper amount of red phosphor and green phosphor into the packing layer.

6. A white light emitting component for producing white light emission by means of secondary light excitation comprising a LED chip which emits violet or ultra violet light with wavelength between 360 ~ 420 nm and a resin packing layer coated on the LED chip, wherein the resin packing layer is a mixture of packing material, blue phosphor and yellow phosphor, and the blue phosphor is selected from the group consisting of Sr₁₀(PO₄)₆Cl₁₂:Eu²⁺, Ca₁₀(PO₄)₆Cl₁₂:Eu²⁺, Ba₁₀(PO₄)₆Cl₁₂:Eu²⁺, Sr₅(PO₄)₃Cl:Eu²⁺ and (BaMgAl₁₀O_{17:}Eu²⁺,Mn²⁺), and the yellow phosphor is selected from the group consisting of Y₃Al₅O₁₂:Ce³⁺, Y₃Ga₅O₁₂:Ce³⁺, Gd₃Al₅O₁₂:Ce³⁺, and Gd₃Ga₅O₁₂:Ce³⁺.

7. The while light emitting component as described in claim 6, wherein the resin packing layer further contains green phosphor, and the green phosphor is selected from the group consisting of (BaMg₂Al₁₆O₂₇:Eu²⁺,Mn²⁺), (YBO₃:Ce³⁺,Tb³⁺), SrAl₂S₄:Eu²⁺, BaAl₂S₄:Eu²⁺, CaAl₂S₄:Eu²⁺, SrGa₂S₄:Eu²⁺, BaGa₂S₄:Eu²⁺, and CaGa₂S₄:Eu²⁺.

8. The white light emitting semiconductor component as described in claim 6, wherein the resin packing layer further contains red phosphor, and the red phosphor is selected from the group consisting of (Y₂O₂S:Eu²⁺,Bi³⁺), (YVO₄:Eu²⁺,Bi³⁺), SrS:Eu²⁺, SrY₂S₄:Eu²⁺, CaLaS₄:Ce³⁺, CaS:Eu²⁺, and SrS:Eu²⁺.

9. The white light emitting semiconductor component as described in claim 7, wherein the resin packing layer further contains red phosphor, and the red phosphor is selected from the group consisting of (Y₂O₂S:Eu²⁺,Bi³⁺), (YVO₄:Eu²⁺,Bi³⁺), SrS:Eu²⁺, SrY₂S₄:Eu²⁺, CaLaS₄:Ce³⁺, CaS:Eu²⁺, and SrS:Eu²⁺.

10. The white light emitting semiconductor component as described in claim 8, wherein if the total weight of the packing layer is A; the weight of the packing material is E; the weight of the blue phosphor is B; the weight of the yellow phosphor is Y; the weight of the red phosphor is R; and the weight of the green phosphor is G; then relation between each individual ingredient in weight shall fulfill the following condition:
E ≧ 50% A;
B+Y+R+G ≦ 50% A;
5% A ≦ B ≦ 40% A;
5% A ≦ Y ≦ 40% A;
0.001% A ≦ R ≦ 20% A; and
0.0001% A ≦ G ≦ 20% A.

11. The white light emitting component as described in claim 9, wherein if the total weight of the packing layer is A; the weight of the packing material is E; the weight of the blue phosphor is B; the weight of the yellow phosphor is Y; the weight of the red phosphor is R; and the weight of the green phosphor is G; then relation between each individual ingredient in weight shall fulfill the following condition:
E ≧ 50% A;
B+Y+R+G ≦ 50% A;
5% A ≦ B ≦ 40% A;
5% A ≦ Y ≦ 40% A;
0.001% A ≦ R ≦ 20% A; and
0.0001% A ≦ G ≦ 20% A.

12. The white light emitting component as described in claim 8, wherein the resin packing layer has a two-layer laminated structure of which the first coating layer is a mixture of the packing material and the blue phosphor, and is coated on the diode chip, and the second coating layer is a mixture of the packing material, the yellow phosphor, the blue phosphor, the red phosphor and the green phosphor, and is coated on the first coating layer, and if the total weight of the first coating layer is A; the weight of the packing material in the first coating layer is E; and the weight of the blue phosphor in the first coating layer is B; then the relation between each individual ingredient in weight shall fulfill the condition of
E ≧ 50% A; and 5% A ≦ B ≦ 50%A;
and if the total weight of the second coating layer is X; the weight of the packing material in the second coating layer is E; the weight of the blue phosphor in the second coating layer is B; the weight of the yellow phosphor in the second coating layer is Y; the weight of the red phosphor in the second coating layer is R; and the weight of the green phosphor in the second layer is G; then the relation between each individual ingredient shall fulfill the following condition:
E ≧ 50% X;
B+Y+R+G ≦ 50% X;
0% X ≦ B ≦ 5% X;
5% X ≦ Y ≦ 50% X;
0.001% X ≦ R ≦ 20% X; and
0.0001% X ≦ G ≦ 20% X.

13. The white light emitting component as described in claim 9, wherein the resin packing layer has a two-layer laminated structure of which the first coating layer is a mixture of the packing material and the blue phosphor, and is coated on the diode chip, and the second coating layer is a mixture of the packing material, the yellow phosphor, the blue phosphor, the red phosphor and the green phosphor, and is coated on the said first coating layer, and if the total weight of the first coating layer is A; the weight of the packing material in the first coating layer is E; and the weight of the blue phosphor in the first coating layer is B; then the relation between each individual ingredient in weight shall fulfill the condition of
E ≧ 50% A; and 5% A ≦ B ≦ 50%A;
and if the total weight of the second coating layer is X; the weight of the packing material in the second coating layer is E; the weight of the blue phosphor in the second coating layer is B; the weight of the yellow phosphor in the second coating layer is Y; the weight of the red phosphor in the second coating layer is R; and the weight of the green phosphor in the second layer is G; then the relation between each individual ingredient shall fulfill the following condition:
E ≧ 50% X;
B+Y+R+G ≦ 50% X;
0% X ≦ B ≦ 5% X;
5% X ≦ Y ≦ 50% X;
0.001% X ≦ R ≦ 20% X; and
0.0001% X ≦ G ≦ 20% X.

14. The white light emitting component as described in claim 12 wherein a third coating layer made of the packing material is further coated on the second coating layer.

15. The white light emitting component as described in claim 13 wherein a third coating layer made of the packing material is further coated on the second coating layer.
